## Europäisches Patentamt
(19) **European Patent Office**
**Office européen des brevets**

(11) Publication number: **0 108 116**
**B1**

(12)                  **EUROPEAN PATENT SPECIFICATION**

(45) Date of publication of patent specification: **28.01.87**

(51) Int. Cl.⁴: **H 05 K 3/40, H 05 K 3/46**

(21) Application number: **83901684.7**

(22) Date of filing: **27.04.83**

(86) International application number:
**PCT/US83/00625**

(87) International publication number:
**WO 83/03944 10.11.83 Gazette 83/26**

(54) **HIGH DENSITY PRINTED WIRING BOARD.**

(30) Priority: **05.05.82 US 374837**

(43) Date of publication of application:
**16.05.84 Bulletin 84/20**

(45) Publication of the grant of the patent:
**28.01.87 Bulletin 87/05**

(84) Designated Contracting States:
**DE FR GB NL SE**

(56) References cited:
**FR-A-1 378 154**
**FR-A-2 117 172**
**US-A-3 391 457**

**IBM Technical Disclosure Bulletin, vol. 11, no. 12, issued May 1969, (New York, US), K.F. Greene: "Producing printed circuit boards", page 1676**

**IBM Technical Disclosure Bulletin, vol. 11, no. 9, issued February 1969, (New York, US), J.F. Smith et al.: "Selective removing dielectric materials", page 1151**

(73) Proprietor: **Hughes Aircraft Company**
**7200 Hughes Terrace P.O. Box 45066**
**Los Angeles California 90045-0066 (US)**

(72) Inventor: **REIMANN, William G.**
**8163 Willow Glen Road**
**Los Angeles, CA 90046 (US)**

(74) Representative: **Colgan, Stephen James et al**
**CARPMAELS & RANSFORD 43 Bloomsbury Square**
**London WC1A 2RA. (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Background of the Invention
#### 1. Field of the Invention

The present invention relates to printed wiring boards and, in particular, to layers therefor having increased, high density conductors and feed-through vias.

#### 2. Description of the Prior Art

The number of conductors, which can be succesfully positioned on a conventional layer of multilayer printed wiring board, is limited primarily by the large pads of copper which provide terminations for the conductors. Each pad, and even more so clusters of pads, effectively block channels or locations for the conductors, making it necessary to move the conductors to other less dense layers in the printed wiring board in order to make a connection. The functions of such pads conventionally are electrical and mechanical. The electrical function is to make an electrical connection at the pad, such as to a feed-through or via in the layer, and for this function, it could be much smaller. The purpose of the mechanical function enables the feedthrough hole to be completely surrounded in a worst tolerance condition and to prevent etchants from attacking the metal in and adjacent to the hole during board fabrication. Thus, the pad must be made very large, typically 0.508 mm (20 mils) or more larger than that needed to satisfy its electrical function.

Specifically, the conventional process of forming an etched feedthrough hole or via begins with a blank comprising a core of dielectric material which is doubly cladded with copper. To form the feed-through, holes are drilled through the blank and made conductive with sequential deposits of electroless and electroplated copper. Photoresist material is then formed in a pattern over all exposed metal on the blank except for the surface conductors, lands and holes. Finally, additional copper, followed by tin-lead solder, is electroplated about and into the plated hole and on the conductive material about the plated hole to form a land area. The photoresist is removed and, using the solder as an etch resistant material, the exposed cladding is etched to form conductors on the surfaces of the blank and to form it into a printed wiring board layer. It is obvious, therefore, that the copper and solder plated pad functions both as a means for electrical connection as well as for protection against etching of the copper in the hole. If these plated through holes were vias in an internal layer of a multilayer printed wiring board, the solder plate would be stripped prior to lamination in order to enhance bonding. As an alternate to plating solder around and into the holes, the holes may be tented with photoresist film before the etching operation.

The size of the land area, which is used to protect the copper deposited in and about the feed-through hole during etching, is determined by three major factors. First, there must be sufficient tolerance, typically of 0.254 mm (10 mils), to afford a proper registration from one photoresist pattern to another. For example, the holes must be surrounded by exposed copper, even though the resist image will be shifted one way or the other due to fabrication tolerances. Second, there must be a tolerance in the location in the various holes to accommodate any off-center hole and, for this purpose, the holes are made approximately 0.152—0.254 mm (6—10 mils) larger than the hole diameter. Third, the land must be further enlarged to protect the copper in the hole from being etched; the predetermined tolerance therefore being about 0.102—0.259 mm (4—10 mils) beyond the hole diameter. The sum of these tolerances and requirements provide a land area which is 0.508—0.762 mm (20—30 mils) larger than the hole. Since the smallest hole diameter typically is 0.343 mm (13.5 mils) in diameter, the smallest sized land area is (33.5—43.5 mils) or two and one-half to three times the size of the hole.

As a result of such large land areas, the conductor density is limited, and the spacing between plated through holes is limited to approximately 1.27 mm (50 mil) centers, a standard in the industry. If it were desired to increase the number of conductors, then more printed wiring board layers would be required to interconnect any given set of component terminations. It is preferable to reduce the number of layers and to increase the density within any given layer.

More recently, hermetic leadless carriers are increasingly being used, with the aim of terminations on 0.508—0.635 mm (20 to 25 mil) centers. Such decreased spacing creates a requirement for even higher density of printed wiring board layers than is achievable using conventional techniques.

### Summary of the Invention

According to the present invention, a method is provided for forming feed-through vias in a printed wiring board from a blank having openings and conductive material placed substantially entirely within the openings thereby to define the vias and their locations, characterised in that all exposed portions of the conductive material are covered with conductive resist material which is of different composition from the conductive material, and that the resist material prevents removal of the conductive material by etchants applied during subsequent formation and coupling of conductors to the vias.

In the preferred embodiments, the present invention avoids and overcomes the problems of the prior art by formation of land areas which serve only to provide an electrical connection and which are at least as small as the conductors which they terminate. For example, feed-throughs or vias of 0.203 mm (8 mils) and less in cross-section are obtainable in printed circuit boards and, therefore, can at least equal the width of the conductors to which they are bonded.

Preferably, to produce such feed-throughs or vias, conductive via material is placed in openings through the dielectric core of the printed wiring board and extend substantially to the opposed copper clad surface of the printed wiring board at the locations of the feed-through vias, thereby exposing the backside of the opposing copper foil. The exposed backside foil in the openings is coated with conductive resist material, and conductive cladding overlays both the dielectric core and the conductive resist material. While the conductive cladding and conductive via material may be of the same substance, the resist material must be of a composition which is different therfrom. Thus, portions of the conductive cladding may be removed, such as by an etchant, but the conductive resist material protects the conductive via material in the openings from being etched.

Several advantages result thereform. Since protection of the plated hole during the etching is no longer a consideration, large pads are no longer required. Each via or feed-through has a dimension which is not necessarily larger than that of the conductor to which it is electrically coupled, e.g., 0.203 mm (8 mils) and smaller. Thus, no conductor channel is blocked by the feed-through and, thererfore, the conductor density can be enormously increased. Also the center-to-center spacing between vias can be reduced from conventional 1.27 mm (50 mil) centers to 0.635 mm (25 mil) or even 0.318 mm (12.5 mil) centers. As a result, the number of printed wiring board layers required to interconnect any given set of component terminations is substantially reduced by allowing full utilization of the surface area of the layer. Further, more terminations per unit area are obtainable than allowed by conventional techniques. Because the number of layers is reduced for a given set of interconnections and terminations, the entire weight of the printed wiring board is reduced. For a given printed wiring board thickness or weight, it is further possible to obtain a higher electrical impedance if the number of layers is reduced by increasing the spacing between layers.

Other aims and advantages as well as a more complete understanding of the present invention will appear from the following explanation of exemplary embodiments and the accompaning drawings thereof.

Brief Description of the Drawings

FIGS. 1—12 depict several of the process steps used to form a printed wiring board layer from a sheet of dielectric material having a single conductive cladding, as shown in FIG. 1, or having a double cladding, as shown in FIG. 2a;

FIG 13 depicts a layer having small vias, formed according to the present invention, and larger conventional land areas; and

FIG. 14 is a cross sectional view of plurality of printed wiring board layers formed according to the teachings of the present invention joined with a conventional plated-through hole using, for example, the layer illustrated in FIG. 13.

Detailed Description of the Invention

To produce a high conductor density layer for a multilayer printed wiring board, the beginning step may use a sheet or blank of dielectric material having a conductive cladding on one or both sides thereof.

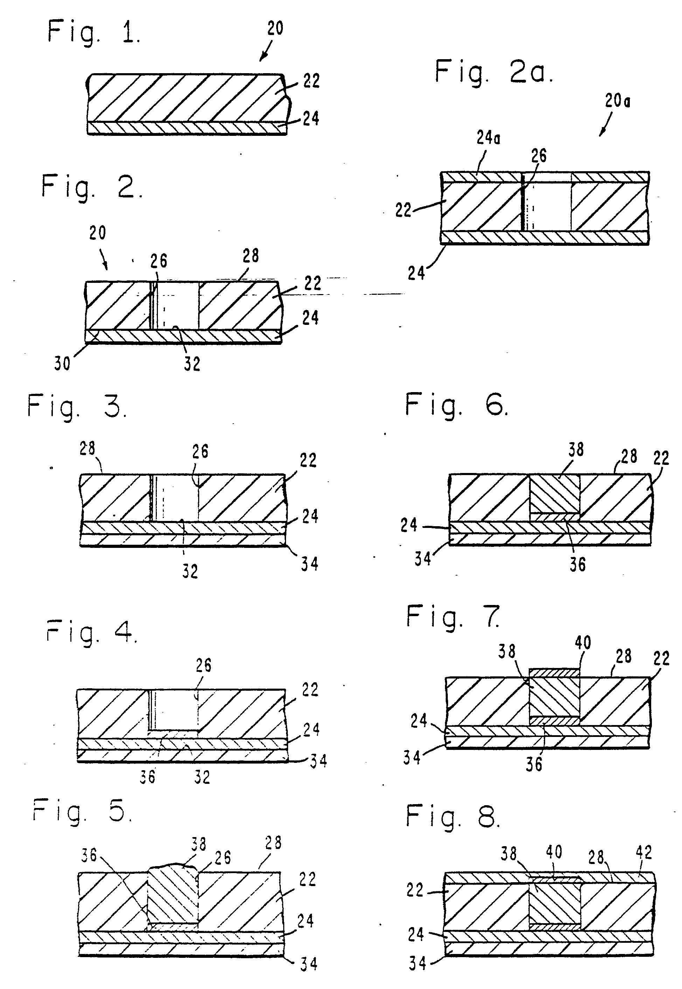

FIG. 1 illustrates a blank 20 having a core 22 of dielectric material with a single layer cladding 24 of conductive material thereon. Core 22 may comprise any conventional dielectric such as epoxy glass, polyimide glass, and epoxy-Kevlar or polyimide-Kevlar. Cladding 24 conventionally comprises one ounce copper, that is, approximately 0.0356 mm (1.4 mils) thick. Using conventional methods of chemical etching or laser drilling, a hole or opening 26 of about 0.127 mm (5 mil) diameter is formed entirely through core 22 from its unclad surface 28 to its clad surface 30 to which cladding 24 is attached. It is to be understood that the diametrical opening size of 0.127 mm (5 mils) is given only for purposes of example and to illustrate that the feedthroughs or vias produced can be at least 2.5 times smaller than the smallest conventional via of about 0.343 mm (13.5 mils) in diameter.

Alternatively, as depicted in FIG. 2a, a doubly clad blank 20a, comprising a dielectric core 22 and a double layer cladding 24 and 24a on both sides thereof, are processed to form an opening 26 therein. The opening is etched or otherwise formed through cladding 24a to provide perforations therethrough, after which a different etchant is used to etch through core 22, perforated cladding 24a acting as a resist therefor. If desired, laser drilling may be used to form hole 26 in core 22, with copper cladding 24a then constituting a reflective mask. Thereafter, cladding 24a is removed, again to form the structure depicted in FIG. 2. At this point, hole 26 has an apporoximate cross-sectional diameter of 0.127 mm (5 mils). Cladding 24 is exposd by hole 26, and its upper layer is designated by indicium 32.

A resist 34 is then placed on the bottom side of cladding 24, as shown in FIG. 3, so that exposed portion 32 of cladding 24 is fully coated, e.g., by electroplating, with a metallic resist 36, such as of gold, nickel, and tin-nickel, to a thickness of approximately 0.00254 to 0.00762 mm (0.0001 to 0.0003 inches), as illustrated in FIG. 4. Dielectric 22 and resist 34 prevent plating on other portions of the blank.

As shown in FIG. 5, hole 26 is then completely filled with a conductive material 38 such as of copper to form a feed-through or via in core 22. Upper surface 28 of core 22 may be sanded to ensure that the copper filling is flush with the top of the hole (e.g., as seen in FIG. 6).

A further metallic resist 40, similar to conductive resist 36 is then electroplated or otherwise deposited on the top surface of copper via 38 at surface 28 of core 22, as viewed in FIG. 7. While both conductive resist materials 36 and 40 are extremely thin, that is from 0.00254 to 0.00762 mm (one ten-thousandths to three ten-thousandths of an inch), for purposes of illustration, these resists are drawn much thicker than they actually are.

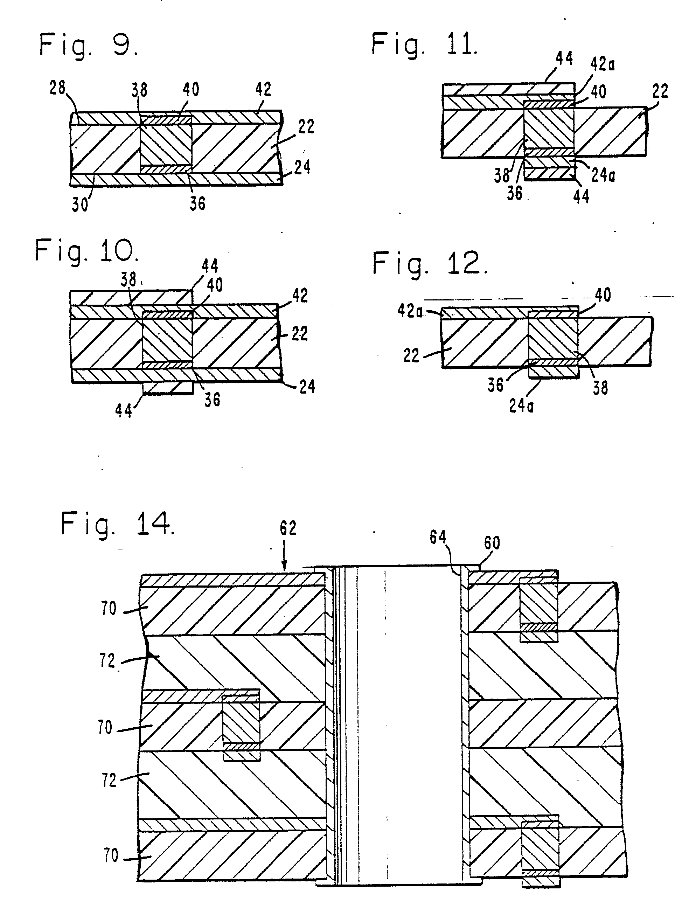

As shown in FIG. 8, the next step involves the placement of a metallic foil 42, for example of copper, on surface 28 of core 22 and over conductive resist 40 by sequential electroless deposition and electroplating processes. Resist 34 is then stripped from cladding 24, to result in the structure of FIG. 9.

Both claddings 24 and 42 are then coated with a photoresist which is configured in a pattern 44 of the desired interconnections (see FIG. 10). Using an etchant which is capable of removing the material of claddings 24 and 42 but not that of metallic resists 36 and 40 and photoresist 42, claddings 24 and 42 are selectively removed, the result being depicted in FIG. 11.

Photoresist 44, if perfectly placed over claddings 24 and 42 and conductive feed-through material 38, might be sufficient to prevent undesired etching of feed-throughs 38 in the absence of conductive resist material 36 and 40. However, in this case any misregistration would expose feed-throughs or vias 38 to undesired removal of material therefrom, which would prevent a proper electrical or mechanical connection thereto. Therefore, the plating of vias 38 by conductive resist 36 and 40 allows for any errors in registration.

Resist material 44 is then removed to produce the finished printed wiring board layer shown in FIG. 12, in which the interconnections made from the claddings are denoted respectively by indicia 24a and 42a. For ease in preparing interconnections amongst the various feed-throughs or vias, interconnections 24a may be placed orthogonally with respect to interconnections 42a.

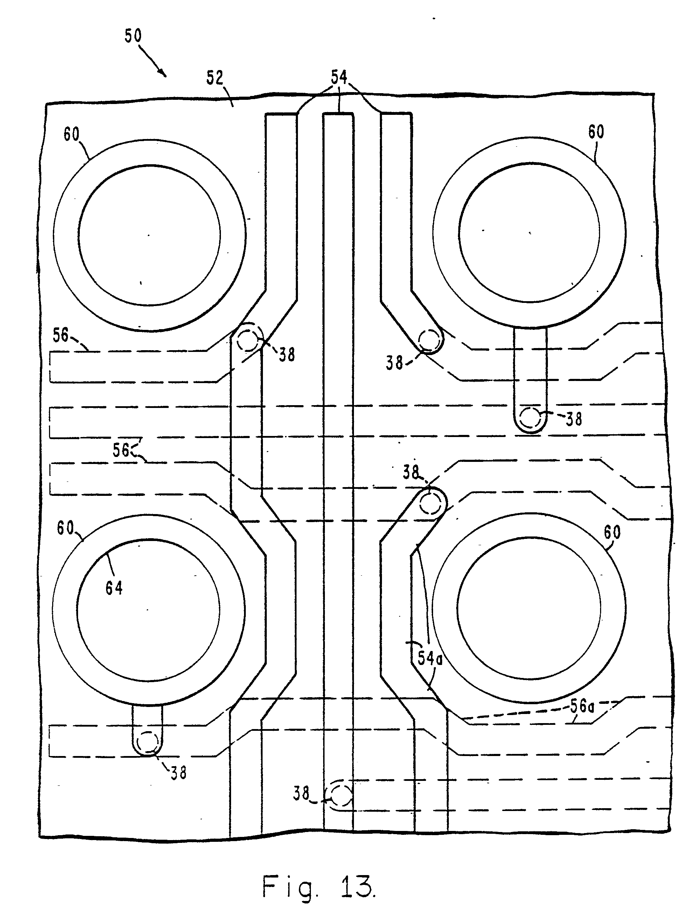

Furthermore, it may be desired to combine the feed-throughs and interconnection conductors formed according to the present invention with the standardized larger land areas of the prior art. Such a modification is illustrated in FIG. 13. A layer 50 comprises a dielectric core 52 having on one side a plurality of interconnection conductor lines 54, which extend generally in parallel, and on the other side another plurality of generally parallel interconnection lines 56 which extend orthogonally with respect to interconnections 54. Lines 54 and 56 are electrically interconnected by a plurality of feed-through vias 38 which are formed according to the teachings of the present invention. In addition, enlarged pads 60, are also formed respectively by etching one or both of the claddings from which conductor lines 54 and 56 were produced. To provide space for enlarged land areas 60, conductor lines 54 and 56 are staggered from straight line configuration as shown, for example, by portions 54a and 56a. Enlarged pads 60 may be used to form feed-through holes in a multilayer printed wiring board 62 as depicted in FIG. 14, which shows illustratively one feed-through hole 64 extending through a plurality of layers 70 joined together by a prepreg material 72 (a pre-impregnated cloth). Each layer 70 may have a configuration similar to that of layer 50 of FIG. 13. Feed-through hole 64 of FIG. 14 is enlarged by annularly configured pads 60a.

**Claims**

1. A method for forming feed-through vias in a printed wiring board from a blank (20) having openings (26) and conductive material (38) placed substantially entirely within the openings thereby to define the vias and their locations, characterised in that all exposed portions of the conductive material are covered with conductive resist material (36, 40) which is of different composition from the conductive material, and that the resist material prevents removal of the conductive material by etchants applied during subsequent formation and coupling of conductors (54, 56) to the vias.

2. A method according to claim 1 further characterised in that the conductive material (38) in the openings is covered with conductive cladding (24, 42) that the conductive resist material (36, 40) is placed between the conductive material and the conductive cladding in which the resist material is differently composed from the conductive material and the conductive cladding, and that portions of the conductive cladding are removed to define interconnections (54, 56) among the vias, with the conductive resist material thus preventing removal of any of the conductive material (38).

3. A method according to claim 2 further characterised in that the conductive cladding is etched with a solution capable of etching the cladding but not the conductive resist material.

4. A method according to claim 2 or 3 further characterised in that the openings (26) in the blank are formed to extend to the conductive cladding (24) on the one side (30) thereof, that a first coating (36) of the conductive resist material is deposited in the openings and on the conductive cladding exposed thereby, that the conductive material (38) is deposited in the openings and in contact with the first coating of the conductive resist material, that a second coating (40) of the conductive resist material is deposited on the conductive material exposed on the other side of the blank, and that a second conductive cladding (42) is placed on the other blank side and in contact with the second conductive resist material coating.

5. A method according to any one of claims 2 to 4 further characterised in that the openings and the conductive material therein are formed with dimensions not exceeding that of the interconnections.

6. A method according to any one of the preceding claims for forming the feed-through vias (38) with 0.200 mm (8 mil) and smaller diameter on at most 0.318 mm (12.5 mil) centers and interconnections (54, 56) thereamongst, further characterised in that the openings (26) are formed in the blank (20) on which a first conductive cladding (24) is positioned on a first side (30) thereof to provide the openings with diameters corresponding to those of the feed-through conductors and locations corresponding to where the feed-through conductors are to be located, that first resist material (34) is placed on the first cladding, that first conductive resist material (36) is placed within the openings and in contact with the cladding, in which the first conductive resist material comprises a material which is different from that of the first cladding, that conductive material (38) is placed within the openings in contact with the first conductive resist material and extending substantially flush with the second side (28) of the blank, in which the conductive material comprises material which is different from that of the first conductive resist material, that second conductive resist material (40) is placed on the conductive material exposed at the second side of the blank, in which the second conductive resist material comprises a material which is different from that of the conductive material and the first cladding, that a second conductive cladding (42) is placed over the second conductive resist material and the second side of the blank, in which the second conductive cladding comprises a material which is different from that of the second conductive resist material, that the first resist material is removed from the first cladding, that further resist material (44) is placed on the first and second claddings in a pattern of the interconnections, that portions of the first and second claddings not protected by the further resist material and the first and second conductive resist material are removed to form the interconnections, and that the further resist material is removed.

7. A method according to any one of the previous claims further characterised in that a sheet is selected to have a core of dielectric material with the first conductive material on the first side thereof, that a resist material is placed on the second side of the core having a pattern of the openings, that the dielectric material exposed by the resist material is etched, and that the resist material is removed.

8. A method according to claim 6 further characterised in that the removing of portions of the first and second claddings includes the forming of enlarged conductive material (60) of greater than 0.254 mm (10 mil) diameter among the feed-through vias in the blank from the first and second claddings, routing the interconnections around the enlarged conductive material, combining the as-processed blank, having the feed-through conductors, enlarged conductive material and routed iterconnections, with other printed wiring board layers to form a multilayer printed wiring board, and forming plated-through openings (64) in the multilayer printed wiring board passing through and in electrical contact with the enlarged conductive material.

9. A printed wiring board made by the method of any preceding claim.

**Patentansprüche**

1. Verfahren zur Herstellung von Durchkontaktierungen in gedruckten Leiterplatten aus einem Rohling (20), der Öffnungen (26) aufweist, in denen Leitermaterial (38) im wesentlichen ganz in den Öffnungen angeorndet ist, wodurch die Durchkontaktierungen und ihre Lage definiert sind, dadurch gekennzeichnet, daß alle freiliegenden Teile des Leitermaterials mit einem leitenden Abdeckmaterial (36, 40) abgedeckt werden, das eine unterschiedliche Zusammensetzung wie das Leitermaterial aufwiest, und daß das Abdeckmaterial das Entfernen des Leitermaterials durch Ätzmittel verhindert, die während dem nachfolgenden Ausbilden und Verbinden von Leiterbahnen (54, 56) mit den Durchkontaktierungen angewendet werden.

2. Verfahren nach Anspruch 1, dadurch gekennzeichnet, daß das Leitermaterial (38) in dem Öffnungen mit einer Leiterschicht (24, 42) abgedeckt wird, daß das leitende Abdeckmaterial (36, 40) zwischen dem Leitermaterial und der Leiterschicht angeordnet ist, wobei das Abdeckmaterial eine andere Zusammensetzung aufweist als das Leitermaterial und die Leiterschicht, und daß Teile der Leiterschicht entfernt werden, um zwischen den Durchkontaktierungen Verbindungen (54, 56) festzulegen, wobei das leitende Abdeckmaterial jegliches Entfernen von Leitermaterial (38) verhindert.

3. Verfahren nach Anspruch 2, dadurch gekennzeichnet, daß die Leiterschicht mit einer Lösung geätzt wird, mit der es möglich ist, die Schicht, jedoch nicht das leitende Abdeckmaterial zu ätzen.

4. Verfahren nach Anspruch 2 oder 3, dadurch gekennzeichnet, daß die Öffnungen (26) in dem Rohling so ausgebildet sind, daß sie sich bis zu einer Seite (30) der Leiterschicht (24) erstrecken, daß eine erste Beschichtung (36) aus dem leitenden Abdeckmaterial in den Öffnungen und der dadurch freigelegten Leiterbeschichtung abgelagert wird, daß das Leitermaterial (38) in dem Öffnungen in Kontakt mit der ersten Beschichtung aus dem leitenden Abdeckmaterial abgelagert wird, daß eine zweite Beschichtung (40) aus dem leitenden Abdeckmaterial auf dem Leitermaterial aufgetragen wird, das auf der anderen Seite des Rohlings freiliegt, und daß eine zweite Leiterschicht (42) auf der anderen Seite des Rohlings in Kontakt mit der zweiten Beschichtung aus leitendem Abdeckmaterial angeordnet wird.

5. Verfahren nach einem der Ansprüche 2 bis 4, dadurch gekennzeichnet, daß die Öffnungen und das sich darin befindliche Leitermaterial solche Abmessungen aufweisen, die die Abmessungen der Verbindungen nicht übersteigen.

6. Verfahren nach einem der vorhergehenden Ansprüche zum Herstellen von Durchkontaktierungen (38) mit 0,200 mm (8 mil) oder kleinerem Durchmesser an höchstens 0,312 mm (12.5 mil) Zentren und Verbindungen (54, 56), dadurch gekennzeichnet, daß die Öffnungen (26) in dem Rohling (20) gebildet werden, auf dem eine erste Leiterschicht (24) auf einer Seite (30) davon angeordnet ist, um die Öffnungen mit Durchmessern entsprechend denen der Durchkontaktierungen und Positionen entsprechend der Positionierung der Durchkontaktierungen zu versehen, daß eine erstes Abdeckmaterial (34) auf der ersten Schicht angeordnet wird, daß ein erstes leitendes Abdeckmaterial (36) in den Öffnungen in Kontakt mit der Schicht angeordnet wird, wobei das erste leitende Abdeckmaterial Material umfaßt, das sich von der ersten Schicht unterscheidet, daß Leitermaterial (38) in den Öffnungen in Kontakt mit dem ersten leitenden Abdeckmaterial angeordnet wird und sich im wesentlichen eben mit der zweiten Seite (28) des Rohlings erstreckt, wobei das Leitermaterial Material umfaßt, das sich von dem des ersten leitenden Abdeckmaterials unterscheidet, daß ein zweites leitendes Abdeckmaterial (40) auf dem auf der zweiten Seite des Rohlings freiliegenden Leitermaterials aufgebracht wird, wobei das zweite leitende Abdeckmaterial Material umfaßt, das sich von dem Leitermaterial und der ersten Schicht unterscheidet, daß eine zweite Leiterschicht (42) über dem zweiten leitenden Abdeckmaterial und der zweiten Seite des Rohlings angeordnet wird, wobei die zweite Leiterschicht Material umfaßt, das sich von dem zweiten leitenden Abdeckmaterial unterscheidet, daß das erste Abdeckmaterial von der ersten Schicht entfernt wird, daß weiteres Abdeckmaterial (44) auf der ersten und zweiten Schicht in einem Muster entsprechend den Verbindungen aufgebracht wird, daß nicht durch das weitere Abdeckmaterial geschützte Teile der ersten und zweiten Schicht und das erste und zweite leitende Abdeckmaterial entfernt werden, um die Verbindungen zu bilden, und daß das weitere Abdeckmaterial entfernt wird.

7. Verfahren nach einem der vorhergehenden Ansprüche, dadurch gekennzeichet, daß ein Blatt mit einem Kern aus dielektrischem Material ausgewählt wird und erstes Leitermaterial auf der ersten Seite davon aufweist, daß ein Abdeckmaterial auf der zweiten Seite des Kerns mit einem Muster der Öffnungen angeordnet wird, Daß das von dem Abdeckmaterial freigegebene dielektrische material geätzt wird, und daß das Abdeckmaterial entfernt wird.

8. Verfahren nach Anspruch 6, dadurch gekennzeichnet, daß das Entfernen der Teile der ersten und zweiten Schicht das Herstellen von vergrößerten Leiterbahnen (60) mit einem Durchmesser von größer als 0,254 mm (10 mil) aus den Durchkontaktierungen in dem Rohling auf der ersten und zweiten Schicht umfaßt, das Herumführen der Verbindungen um die vergrößerten Leiterbahnen umfaßt, das Kombinieren des bearbeiteten Rohlings mit Durchkontaktierungen, vergrößerten Leiterbahnen und umgeleiteten Verbindungen, mit anderen gedruckten Leiterplattenschichten umfaßt, um eine Multilayer-Leiterplatte zu bilden, und das Bilden von durchplattierten Öffnungen (64) in der Multilayer-Leiterplatte umfaßt, die durchgehend sind und in elektrischem Kontakt mit den vergrößerten Leiterbahnen stehen.

9. Gedruckte Leiterplatte, hergestellt nach einem Verfahren nach einem der vorhergehenden Ansprüche.

**Revendications**

1. Procédé pour former des passages de traversée dans une plaquette de câblage imprimé à partir d'un flan (20) possédant des ouvertures (26) et une matière conductrice (38) placée sensiblement entièrement dans les ouvertures afin de définir les passages et leurs positions, caractérisé en ce que toutes les parties exposées de la matière conductrice sont recouvertes d'une réservè photosensible conductrice (36, 40) qui est d'une composition différente de celle de la matiére conductrice, et en ce que la réserve photosensible empêche l'élimination de la matière conductrice par des substances d'attaque appliquées durant la formation et le couplage, ensuite, de conducteurs (54, 56) aux passages.

2. Procédé selon la revendication 1, caractérisé en outre en ce que la matière conductrice (38) présente dans les ouvertures est recoverte d'un revêtement conducteur (24, 42) en ce que la réserve photosensible conductrice (36, 40) est placée entre la mantiére conductrice et le revêtement conducteur, la réserve photosensible ayant une composition différente de celle de la matière conductrice et du revêtement conducteur, et en ce què des parties du revêtement conducteur sont éliminées afin de définir des interconnexions (54, 56) parmi les passages, la réserve photosensible conductrice empêchant ainsi l'élimination d'une partie de la matière conductrice (38).

3. Procédé selon la revendication 2, caractérisé en outre en ce que le revêtement conducteur est attaqué avec une solution capable d'attaquer le revêtement, mais non la réserve photosensible conductrice.

4. Procédé selon la revendication 2 ou 3, charactérise en outre en ce que les ouvertures (26) du flan sont formées de façon à s'étendre jusqu'au revêtement conducteur (24) sur sa première face (30), en ce qu'une première couche (36) de réserve photosensible conductrice est déposée dans les ouvertures et sur le revêtement conducteur exposé par celles-ci, en ce que la matière conductrice (38) est déposée dans les ouvertures et est en contact avec la première couche de réserve photosensible conductrice, en ce qu'une seconde couche (40) de la réserve photosensible conductrice est déposée sur la matière conductrice exposée sur l'autre face du flan, et en ce qu'un second revêtement conducteur (42) est placé sur l'autre face du flan et est en contact avec la seconde couche de réserve photosensible conductrice.

5. Procédé selon l'une quelconque des revendications 2 à 4, caractérisé en outre en ce que les ouvertures et la matière conductrice qu'elles contiennent sont formées à des dimensions ne dépassant pas celles des interconnexions.

6. Procédé selon l'une quelconque des revendications précédentes pour former les passages de traversée (38) à un diamètre de 0,200 mm (8 mils) et moins, à des entraxes de 0,318 mm (12,5 mils) au plus et avec des interconnexions (54, 56) parmi eux, caractérisé en coutre en ce que les ouvertures (26) sont formées dans le flan (20) sur une premiere face (30) duquel un premier revêtement conducteur (24) est placé afin de donner aux ouvertures des diamètres correspondant à ceux des conducteurs de traversée et des positions correspondant à celles dans lesquelles les conducteurs de traversée doivent être placés, en ce qu'une première réserve photosensible (34) est placée sur le premier revêtement, en ce qu'une première réserve photosensible conductrice (36) est placée dans les ouvertures et en contact avec le revêtement, la première réserve photosensible conductrice comprenant une matière qui est différente de celle du premiere revêtement, en ce qu'une matière conductrice (38) est placée dans les ouvertures en contact avec la première réserve photosensible conductrice et s'étendant sensiblement à fleur de la seconde face (28) du flan, la matière conductrice comprenant une matière qui est différente de celle de la première réserve photosensible conductrice, en ce qu'une seconde réserve photosensible conductrice (40) est placée sur la matière conductrice exposée à la seconde face du flan, la seconde réserve photosensible conductrice comprenant une matière qui est différente de la matière conductrice et du premier revêtement, en ce qu'un second revêtement conducteur (42) est placé sur la seconde réserve photosensible conductrice et la seconde face du flan, le second revêtement conducteur comprenant une matière qui est différente de celle de la seconde réserve photosensible conductrice, en ce que la première réserve photosensible est éliminée du premier revêtement, en ce qu'une autre réserve photosensible (44) est placée sur les premier et second revêtements en une configuration des interconnexions, en ce que des parties des premier et second revêtements, non protégées par l'autre réserve photosensible et les première et seconde réserves photosensibles conductrices, sont éliminées pour former les interconnexions, et en ce que l'autre réserve photosensible est éliminée.

7. Procédé selon l'une quelconque des revendications précédentes, caractérisé en outre en ce qu'une feuille est choisie de façon à posséder une âme de matière diélectrique portant, sur sa première face, la première matière conductrice, en ce qu'une réserve photosensible est placée sur la seconde face de l'âme, suivant une configuration des ouvertures, en ce que la matière diélectrique exposée par la réserve photosensible est attaquée, et en ce que la réserve photosensible est éliminée.

8. Procédé selon la revendication 6, caractérisé en outre en ce que l'élimination de parties des premier et second revêtements comprend la formation d'une matière conductrice élargie (60) d'un diamètre supérieur à 0,254 mm (10 mils) parmi les passages de traversée dans le flan, à partir des premier et second revêtements, l'acheminement des interconnexions autour de la matière conductrice élargie, la combinaison du flan tel que traité, comportant les conducteurs de traversée, la matière conductrice élargie et les interconnexions, acheminées, avec d'autres couches de plaquettes de câblage imprimé pour former une plaquette de câblage imprimé multicouche, et la formation d'ouvertures métallisées (64) dans la plaquette de câblage imprimé multicouche passant à travers la matière conductrice élargie et en contact électrique avec cette matière.

9. Plaquette de câblage imprimé produite par le procédé de l'une quelconque des revendications précédentes.

Fig. 1.

Fig. 2a.

Fig. 2.

Fig. 3.

Fig. 6.

Fig. 4.

Fig. 7.

Fig. 5.

Fig. 8.

1

Fig. 9.

Fig. 11.

Fig. 10.

Fig. 12.

Fig. 14.

Fig. 13.